(19) Europäisches Patentamt
European Patent Office
Office européen des brevets

(11) EP 0 387 087 B1

(12) EUROPEAN PATENT SPECIFICATION

(45) Date of publication and mention of the grant of the patent:
**08.10.1997 Bulletin 1997/41**

(51) Int Cl.6: **G03F 7/031**, G03F 7/00

(21) Application number: **90302540.1**

(22) Date of filing: **09.03.1990**

# (54) Photoinitiator compositions, photohardenable compositions and photosensitive microcapsules

Einen Photoinitiator enthaltende Zusammensetzungen, lichthärtbare Zusammensetzungen und lichtempfindliche Mikrokapseln

Compositions contenant un photo-initiateur, compositions photodurcissables et microcapsules photosensibles

(84) Designated Contracting States:
**AT BE CH DE DK ES FR GB GR IT LI LU NL SE**

(30) Priority: **09.03.1989 US 321257**

(43) Date of publication of application:
**12.09.1990 Bulletin 1990/37**

(73) Proprietor: **CYCOLOR, INC.**
**Miamisburg, Ohio 45342 (US)**

(72) Inventors:
- **Davis, Paul**
  **Centerville, Ohio 45459 (US)**
- **Truini, Jacqueline Gale**
  **Dayton, Ohio 45439 (US)**

(74) Representative: **Deans, Michael John Percy et al**
**Lloyd Wise, Tregear & Co.,**
**Commonwealth House,**
**1-19 New Oxford Street**
**London WC1A 1LW (GB)**

(56) References cited:
**EP-A- 0 028 749** **EP-A- 0 223 587**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 387 087 B1

## Description

The present invention relates in its various aspects to photoinitiator compositions, to photohardenable compositions and to photosensitive microcapsules.

It is well known that atmospheric oxygen strongly inhibits the radical initiated polymerization of acrylate monomers, and acrylates typically display a pronounced induction time prior to the onset of polymerization. Kinetic measurements have shown that during the induction time, the concentration of oxygen in acrylate monomer declines due to oxidative reactions, and no detectable polymerization begins until the concentration of oxygen is reduced to a few tenths of a percent of the equilibrium value. Thus, the photographic sensitivity of acrylate photopolymerization systems is governed in large part by this photo-oxidation process.

A photographic process based on the photopolymerization of acrylate monomers developed by The Mead Corporation is described in U.S. Patent Nos. 4,399,209 and 4,440,836, among others. The process differs from other imaging systems based on polymerization reactions in that the photosensitive monomer composition is contained within carbonless type microcapsules along with a photoinitiator and an image-forming agent. Exposure of the imaging sheet hardens the internal phase of the microcapsules and renders them resistant to physical rupture. Thus, a latent image is formed as an image-wise pattern of hard (exposed) and soft (not exposed) microcapsules. The visible image is developed physically by bringing the exposed capsule sheet into contact with a receiver sheet under pressure. Only the soft capsules rupture and deliver the image-forming agent, dissolved in the monomer, to the receiver sheet. The result is a direct positive of the original image. It has been shown that the exposure required to produce the first detectable loss in image density in the microencapsulated acrylate system is a function of the efficiency of photo-oxidation.

In photohardenable acrylate compositions and presumably other photohardenable compositions in which hardening occurs via free radical addition polymerization, the film speed at which there is a detectable change in the hardness of the composition (i.e., the shoulder speed in a positive working composition and the toe speed in a negative working composition) is a product of the quantum efficiency with which the photoinitiator system generates free radicals and the quantum efficiency with which the incipient radicals react with oxygen. To maximize film speed, both efficiencies must be maximized. In our British Patent Specification 2180358 we propose to increase film speed by including a compound in the photoinitiator composition which reacts with oxygen efficiently thereby removing it from the composition such that polymerization proceeds efficiently. This compound is identified as an autoxidizer, and typically takes the form of an N,N-dialkyl aniline.

The autoxidizer selected for use typically is utilized in connection with one or more specific free radical photoinitiators. For example, we have discovered that the dialkyl anilines disclosed in our British Patent 2180358 are particularly effective when utilized in connection with ketone/amine photoinitiators.

In U.S. Patent Nos. 4,772,530 and 4,772,541, also assigned to The Mead Corporation, photoinitiators containing ionic dye compounds are disclosed. The compounds can typically take the form of cationic dye/borate anion compounds or anionic dye/iodium ion compounds. Although the above mentioned dialkyl anilines have been utilized by us as autoxidizers in connection with these photoinitiators, we have discovered that particularly good film speed is obtained if a thiol is used in combination with the aniline autoxidizers.

Despite the success of the above system, the system suffers from a minor number of drawbacks. When using an initiator which is sensitive to acidic compounds such as the cationic dye/borate anion initiators, the presence of the acidic proton in the thiol can potentially deplete the amount of initiator present. It is hypothesized that the proton present in the thiol attacks the carbon-boron bond and causes the complex to dissociate. As a result, the destruction of the borate ion causes a corresponding reduction in the amount of photointiator present. Thus, the "shelf-life" of the photosensitive composition is reduced as a result of the deterioration of the initiator.

Further, when producing photosensitive microcapsules containing an autoxidizer and a thiol compound, due to the acidic nature of the thiol compound, we have found it desirable to add the thiol after the microcapsules are formed by diffusing the thiol into the photohardenable composition through the capsule wall. The acidic thiol is apparently sufficiently soluble in water that it can be partially extracted into the aqueous phase during the encapsulation process if it is added to the photohardenable composition directly, particularly under basic conditions.

U.S. Patent No. 4,304,841 assigned to Hoechst discloses a photopolymerizable mixture which contains a polymeric binder, a compound which is polymerizable by free radical polymerization, a photoinitiator, and a compound of the formula

$$R_1\text{-}CH_2\text{-}S\text{-}S\text{-}CH_2\text{-}R_2$$

wherein $R_1$ and $R_2$ are indentical or different and are alkyl, cycloalkyl, aryl, aralkyl or N-substituted carbamoyl or carbamoylalkyl groups. The disulfide compound is used to reduce the sensitivity of the composition to oxygen. The mixture

only polymerizes when a very high amount of energy is applied to the system (e.g., 5kV halide light source). Further, the effect of the disulfide on oxygen sensitivity is minimal where the mixture is protected against oxygen by the use of polymeric cover sheets. The reference discloses that the disulfide compounds be used in connection with acridine, phenazine, quinoxaline, quinazoline, benzalquinaldine and thiopyrylium initiators. The reference does not disclose that the disulfides be used in association with ionic dye-counter ion photoinitiation systems and does not disclose that the photopolymerizable composition, including the disulfide compounds, can be microencapsulated.

The present invention provides a novel photoinitiator composition and photohardenable compositions and imaging systems employing the same. The photoinitiator system of the present invention is characterized in that it includes a disulphide material as an autoxidizer. In addition to the autoxidizer, the photoinitiator must include an absorber, i.e., a compound which absorbs actinic radiation and generates free radicals alone or in conjunction with a compound (herein referred to as a "co-autoxidizer") which quenches the excited absorber and generates free radicals.

Accordingly, the invention provides, in one aspect thereof, a photoinitiator composition comprising a compound which absorbs actinic radiation and directly or indirectly generates free radicals, and a disulphide compound; wherein said compound which absorbs actinic radiation comprises an ionic dye-counter ion complex.

The present invention also provides photohardenable compositions including the inventive photoinitiator composition. The photohardenable compositions include a free radical addition polymerizable or crosslinkable material and the above defined photoinitiator composition.

In an alternative aspect of the present invention, there is provided photosensitive microcapsules containing an internal phase comprising an image-forming agent, a free radical addition polymerisable or crosslinkable material, and a photoinitiator composition comprising a compound which absorbs actinic radiation and directly or indirectly generates free radicals and a disulphide compound, wherein the compound which absorbs actinic radiation comprises an ionic dye-counter ion complex. Such microcapsules may contain a thiol based autoxidant and can be prepared without having to post-add the thiol to the photohardenable composition.

The disulphide compounds are preferably used in combination with other compounds, particularly aromatic amines which also perform an autoxidative or co-initiation function.

Disulfide compounds which are particularly useful in our system can be generally represented by the Formula (I):

$$R_1\text{-S-S-}R_2 \qquad (I)$$

wherein $R_1$ and $R_2$ are the same or different and can be selected from alkyl ($C_1$-$C_{20}$), cycloalkyl, aralkyl, aryl, substituted or unsubstituted heteroaryl, alkenyl and alkynyl groups.

The invention is hereinafter more particularly described by way of example only.

Our photoinitiator compositions include a disulphide compound and an absorber which absorbs actinic radiation and directly or indirectly generates free radicals upon exposure to actinic radiation. The initiator composition functions to initiate free radical polymerization of a photohardenable or photocrosslinkable monomer.

The disulfide compound primarily functions as an autoxidizer by effectively consuming oxygen to thereby diminish the concentration of oxygen to levels which allow structure forming polymerization. The disulfides preferably are of Formula (I):

$$R_1\text{-S-S-}R_2 \qquad (I)$$

wherein $R_1$ and $R_2$ are the same or different and can be selected from alkyl ($C_1$-$C_{20}$), cycloalkyl, aralkyl, aryl, substituted or unsubstituted heteroaryl, alkenyl and alkynyl groups. Preferred alkyl groups contain 3 to 15 carbon atoms, preferred cycloalkyl groups contain 5 to 8 carbon atoms, preferred aryl groups are of the formula

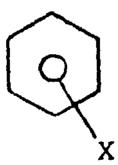

(II)

wherein X is alkyl, alkoxy, halogen, acyl, dialkylamino, trifluoromethyl, hydroxy or alkylaryl groups in the ortho, meta or para positions, or any combination of these. Preferred aralkyl groups include benzyl and naphthylmethyl, preferred

heteroaryl groups include imidazole, oxazole, thiazole, benzimidazole, benzoxazole, and benzothiazole groups.

Representive examples of disulfides which are particularly preferred include symmetrical and asymmetrical disulfides of the following thiols: 2-mercaptobenzothiazole, 6-ethoxy-2-mercaptobenzothiazole, 2-mercaptobenzoxazole, 4-methyl-4H-1,2,4-triazole-3-thiol, 2-mercapto-1-methylimidazole, 2-mercapto-5-methylthio-1,3,4-thiadiazole, 5-n-butylthio-2-mercapto-1,3,4-thiadiazole, 4-methoxybenzenethiol, 1-phenyl-1H-tetrazole-5-thiol, 4-phenyl-4H-1,2,4-triazole-3-thiol, 2-mercaptobenzimidazole, pentaerythritol tetrakis(mercaptoacetate), pentaerythritol tetrakis (3-mercaptoproprionate), trimethylolpropane tris(mercaptoacetate), trimethylolpropane tris(3-mercaptopropionate), 4-acetamidothiophenol, mercaptosuccinic acid, dodecanethiol, 2-mercaptopyridine, 4-mercaptopyridine, 2-mercapto-3H-quinazoline, and 2-mercaptothiazoline, alkylthiophenol, alkoxythiophenol, chlorothiophenol, bromothiophenol, acylthiophenol, dialkylaminothiophenol, trifluoromethylthiophenol, hydroxythiophenol and alkylarylthiophenol wherein the number of carbons in the substituent groups ranges from 1 to 20. More particularly, preferred disulfides include disulfides of 2-mercaptobenzoxazole (MBO), 6-ethoxy-2-mercaptobenzothiazole (EMBT) and phenyl mercaptotetrazole (PMT).

To synthesize useful disulphides a thiol starting material is subject to an oxidative coupling reaction. Examples of such synthesis are set forth in Yoneda et al., "A New Hydrogen-Abstracting Reaction with Diethyl Azodicarboxylate", Journal of the American Chemical Society, 88:10, 1966; Mukaiyama et al., "A Convenient Method for the Preparation of Unsymmetrical Disulfides by the Use of Diethyl Azodicarboxylate", Tetrahedron Letters, 56, pp. 5907-5908, 1968. The coupling reaction can take place by the reaction of the thiol starting material a strong electron accepting agent. Diethyl azodicarboxylate is a preferred electron accepting agent.

In addition to the disulfide autoxidizer, the photoinitiator compositions include an absorber, which is a compound which absorbs actinic radiation and generates a free radical or a compound which absorbs radiation and reacts with a co-initiator to generate a free radical. (The term "actinic radiation" as used herein includes, but is not limited to, visible light, ultraviolet radiation, and infrared radiation, as is determined by the spectral sensitivity of the absorber compound).

Absorbers useful in our compositions include those compounds which are conventionally used or known to be useful as absorbers in the art. Examples are aryl benzophenones such as 4,4'-dimethoxybenzophenone, 4,4'-dichlorobenzophenone, 4,4'-bis(dimethylamino) benzophenone, benzanthone, 9-fluorenone; xanthones such as, xanthone, 2-methylxanthone and 2-dodecylxanthone; thioxanthones such as thiox nthone, 2-methylthioxanthone, 2-dodecylthioxanthone, 2-chlorothioxanthone and 2-isopropylthioxanthone; ketocoumarins such as 3-cinnamoyl-7-diethylaminocoumarin; quinones such as phenanthrenequinones; and compounds such as 2-methyl-1-[4-(methylthio)phenyl]-2-morpholinopropanone-1.

Preferred among these absorbers are thioxanthones, phenanthraquinones, the morpholino compounds, and ketocoumarins. (Examples of ketocoumarins useful in practice of the present invention are disclosed in U.S. Patent 4,713,312 to Adair et al.)

Another class of absorber which is particularly preferred for use in our microcapsule is ionic dye complexes. These complexes are stable, non-transient compounds as opposed to the transient collision generated encounter complexes, exciplexes or contact ion pairs which may be encountered in some photohardenable compositions. Examples of ionic dye complexes useful in practice of the present invention are provided in U.S. Patent No. 4,772,541.

One class of particularly useful ionic dye complex is cationic dye-borate compounds represented by the formula (II)

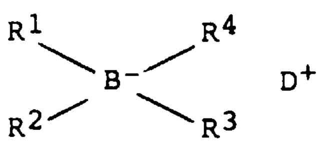

(II)

where $D^+$ is a cationic dye; and $R^1$, $R^2$, $R^3$, and $R^4$ are independently selected from the group consisting of alkyl, aryl, alkaryl, allyl, aralkyl, alkenyl, alkynyl, alicyclic and saturated or unsaturated heterocyclic groups.

Useful dyes form photoreducible, but dark stable, complexes with borate anions and can be cationic methine, polymethine, triarylmethane, indoline, thiazine, xanthene, oxazine and acridine dyes. More specifically, the dyes may be cationic cyanine, carbocyanine, hemicyanine, rhodamine and azomethine dyes. In addition to being cationic, the dyes should not contain groups which would neutralize or desensitize the complex or render the complex poorly dark stable.

Specific examples of useful cationic dyes of Formula II are Methylene Blue, Safranine O, Malachite Green, cyanine dyes of the general formula (III) and rhodamine dyes of the formula (IV):

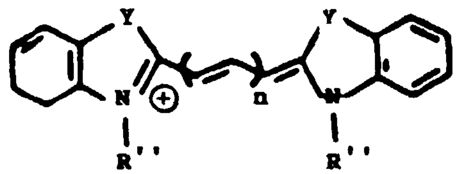

(III)

n = 0, 1, 2, 3,
R" = alkyl
Y = CH=CH, N-$CH_3$, $C(CH_3)_2$, O, S, Se

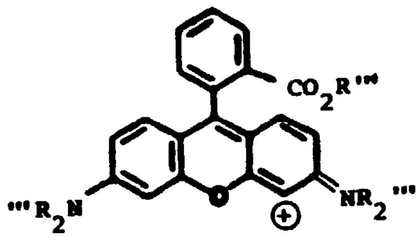

(IV)

R"', $R_2$"' = alkyl, aryl, and any combination thereof

The borate anion of Formula II is selected such that the boranyl radical generated upon exposure to light and after electron transfer to the dye readily dissociates with the formation of a radical as follows:

$$BR_4 \rightarrow BR_3 + R\cdot$$

For example, particularly preferred anions are triphenylbutylborate triphenylbenzylborate, triphenylsecbutylborate, triphenylneopentylborate, and trianisylbutylborate because they readily dissociate to a triarylborane and an alkyl or aralkyl radical. On the other hand tetrabutylborate anion does not work well possibly because the tetrabutylborate radical is not stable and it readily accepts an electron back from the dye in a back electron transfer and does not dissociate efficiently. Likewise, tetraphenylborate anion is very poor because the phenyl radical is not easily formed.

Preferably, at least one but not more than three of $R^1$, $R^2$, $R^3$, and $R^4$ is an alkyl group. Each of $R^1$, $R^2$, $R^3$, and $R^4$ can contain up to 20 carbon atoms, and they typically contain 1 to 10 carbon atoms. More preferably $R^1$ - $R^4$ are a combination of alkyl group(s) and aryl group(s) or aralkyl group(s) and still more preferably a combination of three aryl groups and one alkyl or aralkyl group.

Specific examples of cationic dye-borate anion compounds useful in practice of the present invention are shown in U.S. Patent No. 4,772,541.

The cationic dye-borate anion compounds can be prepared by reacting a borate salt with a dye in a counterion exchange in a known manner. See Hishiki, Y., Repts. Sci. Research Inst. (1953), 29, pp 72-79. Useful borate salts are sodium or magnesium salts such as sodium or magnesium triphenylbutylborate, sodium or magnesium trianisylbutylborate and ammonium salts such as tetraethylammonium triphenylbutylborate.

Anionic dye compounds are also useful as absorbers in our compositions. Anionic dye-iodonium ion compounds of the formula (V):

$$[R^5-\overset{\oplus}{I}-R^6]_n\ D^{-n} \qquad (V)$$

where $D^-$ is an anionic dye and $R^5$ and $R^6$ are independently selected from the group consisting of aromatic nuclei such as phenyl or naphthyl and n is 1 or 2; and anionic dye-pyryllium compounds of the formula (VI):

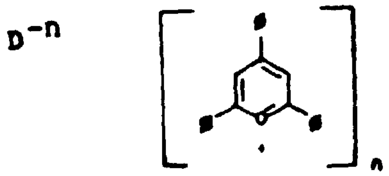

(VI)

where D⁻ and n are as defined above are typical examples of anionic dye complexes.

Representative examples of anionic dyes include xanthene and oxonol dyes. For example Rose Bengal, eosin, erythrosin, and fluorscein dyes are useful. In addition to iodonium and pyryllium ions, other compounds of anionic dyes and sulfonium and phosphonium cations are potentially useful.

Selected examples of anionic dye compounds are shown in U.S. Patent No. 4,772,530.

In addition to the foregoing compounds it may also be desirable to include an N,N-dialkylaniline compound in the photoinitiator composition as a co-initiator or as co-oxidant (depending upon the nature of the dialkylaniline).

Representative examples of N,N-dialkylanilines useful as co-initiators or autoxidizers in our compositions invention are represented by the formula (VII)

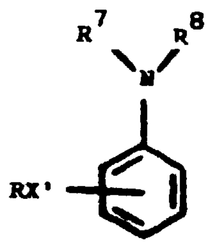

(VII)

where $R^7$ and $R^8$ are alkyl groups having 1 to 6 carbon atoms and preferably 1 to 4 carbon atoms, n is an integer of 1 to 5, and X' is a substituent having a Hammett's (para) constant sigma ($\sigma$) in the range of -0.9 to 0.7. Preferred X' have a Hammett's constant in the range of -0.5 to 0.5 and still more preferred X' have a constant in the range of -0.2 to 0.5. Representative examples of X are a hydrogen atom, a cyano group, a halogen atom (e.g., fluorine, chlorine, or bromine), an alkyl group having 1 to 3 carbon atoms, a hydroxyl group, an alkoxy group having 1 to 3 carbon atoms (e.g., ethoxy), an amino group, a dialkylamino group wherein the alkyl groups have 1 to 3 carbon atoms, an acyl group having 2 to 6 carbon atoms (e.g., acetyl), an acylamido group having 2 to 6 carbon atoms (e.g., acetylamido), an alkylsulfido group having 2 to 4 carbon atoms (e.g., $-SCH_3$), a phenyl group, a hydroxy group and a mercapto group. When n is 2 or 3, the X' groups can be the same or different. The position of the X' substituent(s) affects the ability of the aniline to effect net hydrogen transfer.

Representative examples of N,N-dialkylanilines useful in our compositions are 4-cyano-N,N-dimethylaniline, 4-acetyl-N,N-dimethylaniline, 4-bromo-N,N-dimethylaniline, ethyl 4-(N,N-dimethylamino)benzoate, 3-chloro-N,N-dimethylaniline, 4-chloro-N,N-dimethylaniline, 3-ethoxy-N,N-dimethylaniline, 4-fluoro-N,N-dimethylaniline, 4-methyl-N,N-dimethylaniline, 4-ethoxy-N,N-dimethylaniline, N,N-dimethylthioanicidine, 4-amino-N,N-dimethylaniline, 3-hydroxy-N,N-dimethylaniline, N,N,N',N'-tetramethyl-1,4-dianiline and 4-acetamido-N,N-dimethylaniline.

Examples of more preferred N,N-dialkylanilines are dialkylanilines substituted in the ortho-, meta- or para-position by the following groups: methyl, ethyl, isopropyl, t-butyl, 3,4-tetramethylene, phenyl, trifluoromethyl, acetyl, ethoxycarbonyl, carboxy, carboxylate, trimethylsilymethyl, trimethylsilyl, triethylsilyl, trimethylgermanyl, triethylgermanyl, trimethylstannyl, triethylstannyl, n-butoxy, n-pentyloxy, phenoxy, hydroxy, acetyloxy, methylthio, ethylthio, isopropylthio, thio (mercapto-), acetylthio, fluoro, chloro, bromo and iodo.

Examples of N,N-dialkylanilines useful as co-initiators are ethyl-p-(dimethylamino)benzoate (EPD), 2-n-butoxyethyl-4(dimethylamino)-benzoate, and ethyl o-(dimethylamino)-benzoate. N,N-dialkylanilines substituted with one or two alkyl groups in the ortho-position are often good autoxidizers. Examples of N,N-dialkylanilines typically useful as co-oxidants are 2,6-diisopropyl-N,N-dimethylaniline, 2,6-diethyl-N,N-dimethylaniline, N,N,2,4,6-pentamethylaniline and p-t-butyl-N,N-dimethylaniline.

We have discovered that the disulfides of Formula I act as particularly good autoxidizers when used in connection with cationic dye anionic borate absorbers and with N,N-dialkylanilines, and particularly with N,N-dialkylanilines substituted with one or two alkyl groups in the ortho-position. It had been proposed to use a thiol/aniline co-autoxidizer in

association with the cationic dye-anionic borate absorber but a problem occurred by depletion of the borate anion at temperatures greater than 60°C. It is hypothesized that presence of the acidic hydrogen of the thiol group would undesirably react with the borate ion by attacking the carbon-boron bond. This depletes the amount of borate anion available to generate free radicals. As a result, the efficiency of the photoinitiator composition is significantly reduced. By using a disulfide compound instead of a simple thiol as an autoxidizer, the acidic hydrogen atom associated with the single thiol is eliminated. Accordingly, the disulfide compound does not attack the borate anion and as such, the amount of borate available to generate free radicals is not depleted. Thus, use of a disulfide compound as an autoxidizer can function to maximize the efficiency of the photoinitiator compound.

The photoinitiator composition is incorporated in the photohardenable composition in an amount sufficient to cause the composition to harden upon exposure to actinic radiation and more preferably in an amount sufficient to provide a low film speed. Typical compositions contain up to about 1 part of the absorber per 100 parts of the free radical polymerizable or crosslinkable compound and preferably about 0.5 to 1.5 parts per 100 parts of the free radical addition polymerizable or crosslinkable compound. The ratio will depend on the compounds selected, the extinction coefficients of the absorber, etc. as will be understood in the art.

Our photoinitiator systems may contain about 1.0 to 12% by weight of the disulfides based on the polymerizable monomer.

When present, the N,N-dialkylanilines are used in an amount of about 1.0 to 6% by weight based on polymerizable monomers and the disulfides are used in an amount of about 0.5 to 12% by weight based on the amount of monomer.

Our photoinitiator compositions can be used in combination with substantially any free radical addition polymerizable material. The most typical examples of a free radical addition polymerizable or crosslinkable material useful in practice are ethylenically unsaturated compounds and, more specifically, polyethylenically unsaturated compounds. These compounds include both monomers having one or more ethylenically unsaturated groups, such as vinyl or allyl groups, and polymers having terminal or pendant ethylenic unsaturation. Such compounds are well known in the art and include acrylic and methacrylic esters of polyhydric alcohols such as trimethylolpropane and pentaerythritol; and acrylate or methacrylate terminated epoxy resins and acrylate or methacrylate terminated polyesters. Representative examples include ethylene glycol diacrylate, ethylene glycol dimethacrylate, trimethylolpropane triacrylate (TMPTA), pentaerythritol tetraacrylate, pentaerythritol tetramethacrylate, dipentaerythritol hydroxypentacrylate (DPHPA), hexanediol-1,6-dimethacrylate, and diethyleneglycol dimethacrylate.

While not desiring to be bound, use of disulfide compounds in association with photopolymerizable monomers, we believe, provides more highly crosslinked and higher molecular weight polymers upon exposure of the monomers to actinic radiation. In prior art systems utilizing aniline or thiol autoxidizers, although the compounds have performed very well in their oxygen scavenging function, they tend to decrease the efficiency of the polymerization chemistry. It is hypothesized that when the anilines or thiols are used they function as a chain transfer agent. As a result, the molecular weight of the polymer produced is relatively low and exhibits reduced physical integrity. In embodiments where the polymer is encapsulated with an image-forming agent, the reduced integrity of the polymer may lead to softer capsules and cause unwanted image-forming agent to exude from the microcapsules upon the application of pressure. By comparision, when using a disulfide compound as an autoxidizer, we believe a more highly crosslinked, higher molecular weight polymer results and concomitantly harder capsules are formed.

Our photohardenable compositions may be coated upon a support in a conventional manner and used as a photoresist or in photolithography to form a polymer image or a resist image; or they may be encapsulated as described in U.S. Patent 4,399,209 and used to control the release of an image-forming agent. In a preferred embodiment the photohardenable composition is encapsulated with a color former and images are formed by reacting the color former with a color developer. Still more preferably, the compositions are used in full color panchromatic imaging systems employing microencapsulated acrylates.

The color formers which are useful in the aforementioned embodiment are colorless electron donating type compounds and are well known in the art. Representative examples of such color formers include substantially colorless compounds having in their partial skeleton a lactone, a lactam, a sulfone, a spiropyran, an ester or an amido structure such as triarylmethane compounds, bisphenylmethane compounds, xanthene compounds, fluorans, thiazine compounds and spiropyran compounds. Crystal Violet Lactone and Copikem X, IV and XI are often used. The color formers can be used alone or in combination. A particularly preferred color former is described in U.S. Patent 4,600,678.

A further advantage associated with our compositions is the ease of encapsulation as a result of using the disulfide autoxidizer material. In prior art systems utilizing thiol materials as autoxidizers, encapsulation is complicated by the acidic hydrogen of the thiol. What typically has to be done to form microcapsules is to post-add the thiol by diffusion through the microcapsule wall. By comparison, in practice of the present invention, the disulphide materials used as autoxidizers may be intially combined with the monomer, absorber and image-forming agent and dispersed in an aqueous medium, followed by the formation of microcapsule walls around the dispersed phase in an otherwise conventional manner.

The developer materials conventionally employed in carbonless paper technology are also useful in practice of

the present invention. Illustrative examples are clay minerals such as acid clay, active clay and attapulgite; organic acids such as tannic acid, gallic acid and propyl gallate; acid polymers such as phenol-formaldehyde resins, phenol acetylene condensation resins and condensates between an organic carboxylic acid having at least one hydroxy group and formaldehyde; metal salts or aromatic carboxylic acids such as zinc salicylate, tin salicylate, zinc 2-hydroxy naphthoate, zinc 3,5 di-tert-butyl salicylate, zinc 3,5-di-(α-methylbenzyl)salicylate, oil soluble metal salts or phenol-formaldehyde novolak resins (e.g., see U.S. Patent Nos. 3,672,935; 3,732,120 and 3,737,410) such as zinc modified oil soluble phenol-formaldehyde resin as disclosed in U.S. Patent No. 3,732,120, zinc carbonate and mixtures thereof.

A particularly preferred developer is a finely divided thermoplastic phenolic resin which can be coalesced by heating after transfer of the color former as described in our European Patent Specification EP-A-026129.

The invention is illustrated in more detail by the following non-limiting example:

Example

The following photosensitive composition used as a control was prepared by mixing together the following compounds:

| | |
|---|---|
| Trimethylolpropane triacrylate | 150 g |
| 1,1'di-n-heptyl-3,3,3',3'-tetramethylindodicarboxyanine triphenyl-n-butyl borate | 1.2 g |
| 2,6-diisopropyl-N-N-dimethyl aniline | 1.5 g |
| Cyan color forming agent (Hilton Davis HD-5430) | 18 g |

The composition was encapsulated in melamine formaldehyde microcapsules. The photographic properties of the control composition were measured by using a step wedge and the properties are shown in Table 1.

The disulfide of 6-ethoxy-2-mercaptobenzothiozale (EMBTD)

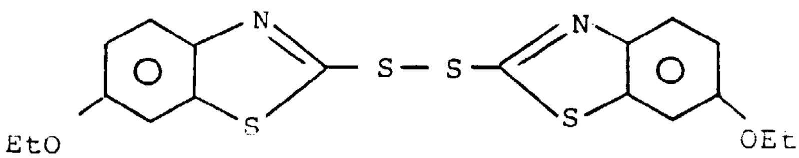

was prepared by reacting EMBT in the presence of diethyl azodicarboxylate. 2 grams and 4 grams of the disulfide (EMBTD) respectively were added to the control composition and the photographic properties of the resulting compositions are shown in Table 1. The compositions containing the disulfide compounds demonstrated improved sensitivity and were capable of producing highly contrasted images as demonstrated by the high gamma values.

Table 1

| Sample | Log 90 (step no.) | Log 10 (step no.) | Dynamic range (steps) | gamma |
|---|---|---|---|---|
| Control | 3.44 | 4.01 | .57 | 3.62 |
| Control + 2g EMBTD | 3.16 | 3.54 | .38 | 5.76 |
| Control + 4g EMBTD | 3.12 | 3.52 | .40 | 5.36 |

**Claims**

**1.** A photoinitiator composition comprising a compound which absorbs actinic radiation and directly or indirectly generates free radicals, and a disulphide compound; wherein said compound which absorbs actinic radiation comprises an ionic dye-counter ion complex.

**2.** A composition according to Claim 1, wherein said ionic dye-counter ion compound comprises a cationic dye-anionic borate complex.

**3.** A composition according to Claim 1 or Claim 2, wherein said composition additionally comprises a compound which functions as a co-autoxidizer.

4. A composition according to Claim 3, wherein said co-autoxidizer comprises a dimethyl alkyl aniline, preferably 2,6-diisopropyl-N,N-dimethyl aniline.

5. A composition according to any preceding claim, wherein said disulphide compound is a compound of the Formula (I):

$$R_1\text{-S-S-}R_2 \qquad (I)$$

wherein $R_1$ and $R_2$ are the same or different and are selected from alkyl ($C_1$-$C_{20}$), cycloalkyl, aralkyl, aryl, substituted or unsubstituted heteroaryl, alkenyl and alkynyl groups.

6. A composition according to Claim 6, wherein said disulphide compound is 6-ethoxy-2-mercaptobenzothiazole disulphide.

7. A photohardenable composition comprising a free radical addition polymerizable or crosslinkable material and a photoinitiator composition according to any preceding claim.

8. A composition according to Claim 7, wherein said composition is microencapsulated with an image-forming agent.

9. Photosensitive microcapsules containing an internal phase comprising an image-forming agent, a free radical addition polymerisable or crosslinkable material, and a photoinitiator composition comprising a compound which absorbs actinic radiation and directly or indirectly generates free radicals and a disulphide compound wherein said compound which absorbs actinic radiation comprises an ionic dye-counter ion complex.

10. Microcapsules according to Claim 9, wherein said ionic dye-counter ion complex comprises a cationic dye-anionic borate complex.

11. Microcapsules according to Claim 9 or Claim 10, wherein said disulphide is a compound of the Formula (I):

$$R_1\text{-S-S-}R_2 \qquad (I)$$

wherein $R_1$ and $R_2$ are the same or different and can be selected from alkyl ($C_1$-$C_{20}$), cycloalkyl, aralkyl, aryl, substituted or unsubstituted heteroaryl, alkenyl and alkynyl groups.

12. Microcapsules according to any of Claims 9 to 11, wherein said photoinitiator composition further comprises a compound which functions as a co-autoxidizer.

13. Microcapsules according to Claim 12, wherein said co-autoxidizer comprises a dimethyl alkyl aniline.

14. Photosensitive material comprising microcapsules according to any of Claims 9 to 13 coated on to a support.

**Patentansprüche**

1. Photoinitiator-Zusammensetzung, die eine Verbindung, welche photoaktive Strahlung absorbiert und direkt oder indirekt freie Radikale erzeugt, und eine Disulphid-Verbindung umfaßt, wobei die die photoaktive Strahlung absorbierende Verbindung einen Komplex aus ionischem Farbstoff und Gegenion umfaßt.

2. Zusammensetzung nach Anspruch 1, bei der die Verbindung aus ionischem Farbstoff und Gegenion einen Komplex aus kationischem Farbstoff und anionischem Borat umfaßt.

3. Zusammensetzung nach Anspruch 1 oder 2, die zusätzlich eine als Co-Autoxydator fungierende Verbindung umfaßt.

4. Zusammensetzung nach Anspruch 3, bei der der Co-Autoxydator ein Dimethylalkylanilin umfaßt, vorzugsweise

2,6-Diisopropyl-N,N-dimethylanilin.

5. Zusammensetzung nach einem der vorangegangenen Ansprüche, bei der die Disulphid-Verbindung eine Verbindung der Formel (I):

$$R_1\text{-S-S-}R_2 \qquad (I)$$

ist, in der $R_1$ und $R_2$ untereinander gleich oder voneinander verschieden sind und aus der Menge der Alkyl-($C_1$-$C_{20}$), Cycloalkyl-, Aralkyl-, Aryl-, substituierten oder nicht substituierten Heteroaryl-, Alkenyl- und Alkinyl-Gruppen gewählt werden.

6. Zusammensetzung nach Anspruch 6, bei der die Disulphid-Verbindung 6-Ethoxy-2-mercaptobenzothiazoldisulphid ist.

7. Lichthärtbare Zusammensetzung, die ein durch radikalische Polymerisation polymerisierbares oder vernetzbares Material und eine Photoinitiator-Zusammensetzung nach einem der vorangegangenen Ansprüche umfaßt.

8. Zusammensetzung nach Anspruch 7, wobei die Zusammensetzung mit einem bilderzeugenden Agens mikroverkapselt ist.

9. Lichtempfindliche Mikrokapseln, deren innere Phase ein bilderzeugendes Agens, ein durch radikalische Polymerisation polymerisierbares oder vernetzbares Material und eine Photoinitiator-Zusammensetzung umfaßt, die eine Verbindung, welche photoaktive Strahlung absorbiert und direkt oder indirekt freie Radikale erzeugt, und eine Disulphid-Verbindung umfaßt, wobei die die photoaktive Strahlung absorbierende Verbindung einen Komplex aus ionischem Farbstoff und Gegenion umfaßt.

10. Mikrokapseln nach Anspruch 9, bei denen der Komplex aus ionischem Farbstoff und Gegenion einen Komplex aus kationischem Farbstoff und anionischem Borat umfaßt.

11. Mikrokapseln nach Anspruch 9 oder 10, bei denen das Disulphid eine Verbindung der Formel (I):

$$R_1\text{-S-S-}R_2 \qquad (I)$$

ist, in der $R_1$ und $R_2$ untereinander gleich oder voneinander verschieden sind und aus der Menge der Alkyl-($C_1$-$C_{20}$), Cycloalkyl-, Aralkyl-, Aryl-, substituierten oder nicht substituierten Heteroaryl-, Alkenyl- und Alkinyl-Gruppen gewählt werden können.

12. Mikrokapseln nach einem der Ansprüche 9 bis 11, bei denen die eine Photoinitiator-Zusammensetzung, ferner eine als Co-Autoxydator fungierende Verbindung umfaßt.

13. Mikrokapseln nach Anspruch 12, bei denen der Co-Autoxydator ein Dimethylalkylanilin umfaßt.

14. Lichtempfindliches Material, das Mikrokapseln nach einem der Ansprüche 9 bis 13 umfaßt, die auf einem Träger geschichtet sind.

**Revendications**

1. Composition de photoinitiateur comprenant un composé disulfure et un composé absorbant les radiations actiniques et générant directement ou indirectement des radicaux libres dans laquelle ce dernier composé comprend un complexe fait d'un colorant ionique et d'un ion de charge contraire.

2. Composition selon la revendication 1, dans laquelle le composé de colorant ionique et d'un ion de charge contraire comprend un complexe fait d'un colorant cationique et de borate anionique.

**3.** Composition selon la revendication 1 ou la revendication 2, comprenant en outre un composant jouant le rôle de co-auto-oxydant.

**4.** Composition selon la revendication 3, dans laquelle le co-auto-oxydant comprend une diméthyle alkyle aniline et de préférence la 2,6-diisopropyl-N,N-diméthyle aniline.

**5.** Composition selon l'une quelconque des revendications précédentes, dans laquelle le composé disulfure a la formule (I) :

$$R_1\text{-S-S-}R_2 \qquad (I)$$

dans laquelle $R_1$ et $R_2$ sont identiques ou différents et sont choisis dans le groupe composé des groupements alkyle ayant de 1 à 20 atomes de carbone, cycloalkyle, aralkyle, aryle, hétéroaryle substitué ou non substitué, alkényle et alkynyle.

**6.** Composition selon la revendication 6, dans laquelle le composé disulfure est le disulfure de 6-éthoxy-2-mercaptobenzothiazole.

**7.** Composition photodurcissable selon l'une quelconque des revendications précédentes comprenant un matériau d'addition polymérisable ou réticulable à radicaux libres.

**8.** Composition selon la revendication 7, cette composition étant microencapsulée avec un agent pour la formation d'images.

**9.** Microcapsules photosensibles contenant une phase interne comprenant un agent pour la formation d'images, un matériau d'addition polymérisable ou réticulable à radicaux libres et une composition comportant un composé disulfure et un composé absorbant les radiations actiniques et générant directement ou indirectement des radicaux libres, ce dernier composé comprenant un complexe fait d'un colorant ionique et d'un ion de charge contraire.

**10.** Microcapsules selon la revendication 9, dans lesquelles le complexe fait d'un colorant ionique et d'un ion de charge contraire comprend un complexe de colorant cationique et de borate anionique.

**11.** Microcapsules selon la revendication 9 ou la revendication 10, dans lesquelles le disulfure a la formule (I)

$$R_1\text{-S-S-}R_2 \qquad (I)$$

dans laquelle $R_1$ et $R_2$ sont identiques ou différents et sont choisis dans le groupe composé des groupements alkyle ayant de 1 à 20 atomes de carbone, cycloalkyle, aralkyle, aryle, hétéroaryle substitué ou non substitué, alkényle et alkynyle.

**12.** Microcapsules selon l'une quelconque des revendications 9 à 11, dans lesquelles la composition de photoinitiateur comprend en outre un composé jouant le rôle d'un co-auto-oxydant.

**13.** Microcapsules selon la revendication 12, dans lesquelles le co-auto-oxydant comprend une diméthyle alkyle aniline.

**14.** Matériau photosensible comprenant des microcapsules selon l'une quelconque des revendications 9 à 13 couchées sur un support.